# EUROPEAN PATENT SPECIFICATION

(11) **EP 2 071 910 B1**
(45) Date of publication and mention of the grant of the patent: **15.09.2010**
(21) Application number: 07816892.9
(22) Date of filing: 27.11.2007
(51) Int. Cl.: H05K 7/20

(54) **METHOD OF HEAT DISSIPATING FOR PLUG-IN BOXES IN CABINET AND AIR-GUIDING APPARATUS**
VERFAHREN ZUR WÄRMEABLEITUNG FÜR EINSTECKKÄSTEN IM GEHÄUSE UND LUFTLEITVORRICHTUNG
PROCEDE DE DISSIPATION DE CHALEUR POUR DES BOITES ENFICHABLES DANS UNE ARMOIRE ET APPAREIL DE GUIDAGE D'AIR

(30) Priority: 17.04.2007 CN 200710101444
(43) Date of publication of application: 17.06.2009
(73) Proprietor: Huawei Technologies Co., Ltd., Longgang District, Shenzhen Guangdong 518129 (CN)
(72) Inventor: AO, Feng, Guangdong 518129 (CN); PAN, Denghai, Guangdong 518129 (CN); CHEN, Haiping, Guangdong 518129 (CN); YAN, Zefei, Guangdong 518129 (CN)
(74) Representative: Körber, Martin Hans
(86) International application number: PCT/CN2007/003349
(87) International publication number: WO 2008/124981

(56) References cited:
- EP-A- 0 020 084
- CN-A- 1 652 675
- CN-A- 1 752 623
- CN-A- 101 014 236
- CN-Y- 2 724 365
- DE-A1- 2 409 683
- DE-U1- 9 001 929
- FR-A- 2 219 612
- US-A- 3 874 444

## Description

### FIELD OF THE INVENTION

The present invention relates to the communication field, and in particular, to a method and an air deflector for radiating heat of subracks in a cabinet.

### BACKGROUND

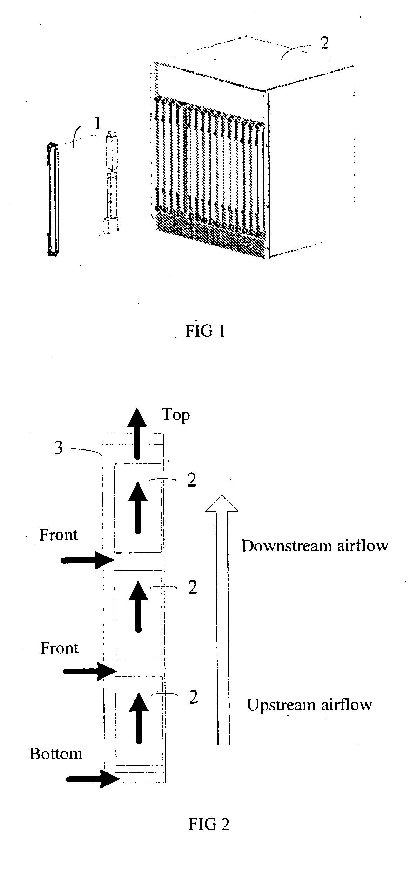

Currently, communication equipment takes the shape of a subrack. As shown in Figure 1, the circuit board 1 is a basic unit of a subrack 2. The circuit board 1 is inserted into the subrack 2 to connect with the backplane and obtain the power supply, and communicate with other circuit boards 1 in the subrack 2. Two or more subracks 2 are installed in one cabinet to constitute cabinet-class communication equipment which is of higher specifications and is more complete. For example, as shown in Figure 2, three subracks 2 are installed into a vertical cabinet 3 from bottom upward, thus constituting cabinet-class communication equipment.

The circuit board 1 in the subrack 2 carries various electronic heat-emitting components. Therefore, when communication equipment works, the cooling air needs to be transmitted to the cabinet 3 so that the cooling air passes through all subracks 2 to radiate heat for the heat-emitting components on each circuit board 1, thus ensuring that the cabinet-class communication equipment works normally and prolonging the service life of the cabinet-class communication equipment.

As shown in Figure 2, if the cabinet 3 of the cabinet-class communication equipment is a small cabinet (for example, 300-depth ETSI telecom cabinet), the cabinet 3 needs to be installed against the wall, and other cabinets 3 are placed to the left side and right side of the cabinet 3. Therefore, the cooling air to the cabinet 3 flows in and out through the front, bottom and top of the cabinet only. Generally, the cooling air of small cabinets flows from bottom upward, namely, the cooling air is led in from the front or bottom of the cabinet 3 and led out from the top of the cabinet 3. Along the circulation direction of airflow, the heat of the subrack on the upstream part of the airflow is carried to the downstream part. Therefore, the temperature of the downstream subrack rises. The subracks closer to the air exhaust side have higher temperatures, which tend to exceed the upper limit of the temperature (about 70 °C), thus affecting the transmission performance of the electronic components on the circuit board of the subrack and making the subrack fail.

The prior art puts forward two solutions to the foregoing problem.

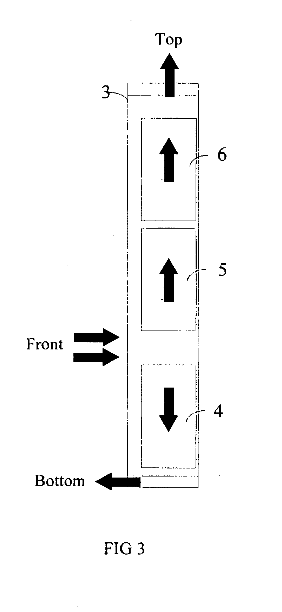

As shown in Figure 3, the first solution is: The cooling air is led in from the front of the cabinet 3, and led out from the top and bottom of the cabinet 3. In the first solution, the incoming cooling air is divided into two channels, and is transmitted downward to the first subrack 4 for radiating heat, and transmitted upward to the second subrack 5 and third subrack 6 for radiating heat. In this way, the cooling air divided in two channels does not carry the heat of the first subrack 4 at the bottom of the cabinet 3 to the third subrack 6, and the third subrack 6 never incurs difficulty of radiating heat due to overheat. However, the first solution has weaknesses. As shown in Figure 3, the first subrack 4 needs to expel air downward, and the second subrack 5 and third subrack 6 need to expel air upward. If the structure of the first subrack 4, the structure of the second subrack 5 and the structure of the third subrack 6 are exactly the same, it is difficult to implement the first solution in the same cabinet.

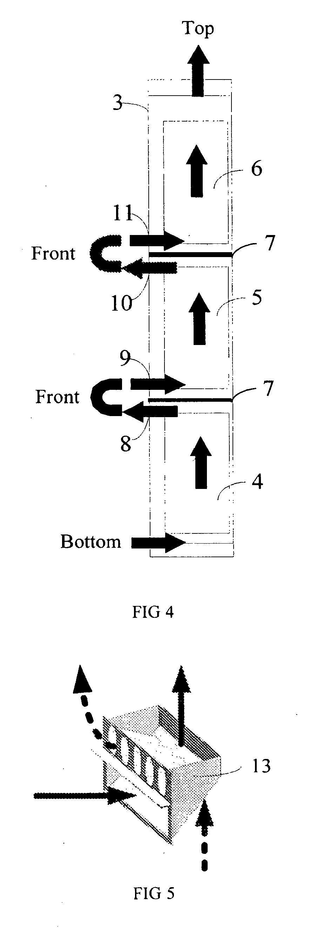

As shown in Figure 4, the second solution is: The cooling air is led in from the front and bottom of the cabinet 3, and led out from the front and top of the cabinet 3. In the second solution, a baffle 7 is set between the first subrack 4, second subrack 5 and third subrack 6. Therefore, the cooling air that passes through the first subrack 4 and second subrack 5 can be led out of the cabinet 3 only through the air exhaust vent 8 set in the front of the cabinet 3. This prevents the cooling air from carrying the heat of the first subrack 4 and second subrack 5 to the third subrack 6 to some extent, thus improving the heat radiation of the third subrack 6. However, the second solution also involves weaknesses. As shown in Figure 4, the air exhaust vent 8 is too close to the air intake vent 9 in the front of the cabinet 3. The cooling air led out from the air exhaust vent 8 of the first subrack 4 is inevitably inhaled by the air intake vent 9 of the second subrack 5, and the cooling air led out from the air exhaust vent 10 of the second subrack 5 is also inevitably inhaled by the air intake vent 11 of the third subrack 6. Consequently, the heat of the first subrack 4 and second subrack 5 is still carried to the third subrack 6, thus deteriorating the heat radiation capability of the third subrack 6.
EP-A-0 020 084 discloses a natural air cooled rack for vertically disposed printed boards comprising a plurality of stacked cases for housing printed boards, wherein each of the cases has draught openings on the upper surface and the lower surface thereof.
FR-A-2 219 612 discloses aeration elements comprising bosses and recesses, wherein said elements have cold air inlets and hot air outlets being placed on opposite sides. In the inside of the element a plan is arranged so as to guide the heated air in the direction of the outlet.
DE 90 01 929 U1 discloses a ventilator insert which dissipates lost heat of electrical elements and units.

### SUMMARY

The present invention provides a method for radiating heat of subracks in a cabinet, wherein the subracks are installed from bottom upward in the cabinet. The method further comprises the steps of leading at least two channels of heat-radiating airflow into the subracks; of, among at least two channels, leading one channel which has passed through some subracks out of the cabinet from two adjacent subracks, with this channel passing through no more subracks, and of leading another channel into other subracks which need to radiate heat. The channel of airflow led out of the cabinet and the channel of airflow led into the cabinet intersect and are isolated from each other by a first baffle, which is set between an air exhaust vent of the one channel and an air intake vent of the another channel.

Favorably, the airflow that has passed through some subracks is led from a lateral plane of the cabinet to outside of the cabinet; and/or the airflow that has passed through some subracks is led from top of the cabinet to the outside of the cabinet.

The present invention also discloses an air deflector, which comprises a frame; a first duct, set inside the frame, wherein an air intake vent and an air exhaust vent of the first duct are located at both sides of the frame; and a second duct, set inside the frame, wherein an air exhaust vent of the second duct and an air intake vent of the first duct are located at two opposite sides of the frame; and a first baffle, set between the air exhaust vent of the first duct and the air intake vent of the second duct to isolate the second duct and the first duct intersect.
Favorably, the air intake vent of the second duct and the air exhaust vent of the first duct are located on a same lateral plane of the frame.
Favorably, the air deflector further comprises a second baffle, set at a side opposite to the first baffle on the air exhaust vent of the first duct.
Favorably, the air intake vent and the air exhaust vent of the first duct are located at two opposite sides of the frame respectively, and the air intake vent and the air exhaust vent of the second duct are located at two opposite sides of the frame respectively. Favorably, the air intake vent of the first duct is set as a bevel.
Favorably, the first duct is composed of multiple air channels, spacing exists between the multiple air channels, and the spacing constitutes the second duct.
Favorably, the multiple air channels are in a cylinder or tuyere shape.

The present invention also provides a communication apparatus, which comprises a cabinet and at least two subracks, wherein the subracks are installed in the cabinet from bottom upward, and an air deflector is set between at least two adjacent subracks. Furthermore, the air deflector comprises a frame; a first duct, set inside the frame, wherein an air intake vent and an air exhaust vent of the first duct are located at both sides of the frame; and a second duct, set inside the frame, wherein an air exhaust vent of the second duct and an air intake vent of the first duct are located at two opposite sides of the frame; and a first baffle, set between the air exhaust vent of the first duct and the air intake vent of the second duct to isolate the second duct and the first duct intersect; wherein, among the two ducts, one duct leads airflow that has passed through some subracks out of the cabinet and this airflow does not pass through any other subrack, and the other duct leads airflow that does not pass through any subrack into other subracks that need heat radiation.
Favorably, the air intake vent of the second duct and the air exhaust vent of the first duct in the air deflector are located on a same lateral plane of the frame.
Favorably, the air deflector further comprises a second baffle, set at a side opposite to the first baffle on the air exhaust vent of the first duct.
Favorably, the air intake vent and the air exhaust vent of the first duct in the air deflector are located at two opposite sides of the frame respectively, and the air intake vent and the air exhaust vent of the second duct are located at two opposite sides of the frame respectively.
Favorably, a lateral plane of the air intake vent of the first duct set in the air deflector is a bevel.
Favorably, the first duct in the air deflector is composed of multiple air channels, spacing exists between the multiple air channels, and the spacing constitutes the second duct.
Favorably, the multiple air channels are in a cylinder or tuyere shape.
Favorably, spacing exists between the lateral plane which has an air intake vent on the cabinet and the subracks, and a channel of airflow which has passed through some subracks is led out of the cabinet through the spacing.
Favorably, the air exhaust vent for exhaling the airflow on the cabinet and the air intake vent are set on a same lateral plane of the cabinet, and the air exhaust vent is located above the air intake vent.
Favorably, the air exhaust vent for exhaling the airflow on the cabinet is located on top of the cabinet, and the airflow which has passed through some subracks in the cabinet is led out of the cabinet through the air exhaust vent.
Favorably, the air exhaust vent is set at the lateral plane and the top of the cabinet, the airflow which has passed through some subracks nearby bottom of the cabinet is led out of the cabinet through the air exhaust vent set on the lateral plane of the cabinet; the airflow which has passed through some subracks nearby the top of the cabinet is led out of the cabinet through the air exhaust vent set at the top of the cabinet.

The embodiments of the present invention lead at least two channels of heat-radiating airflow into the subracks, and lead one channel that has passed through some subracks out of the cabinet from between two adjacent subracks so that this channel of airflow does not pass through any other subrack. In this way, the heat accrual of the subrack is controlled in the circulation direction of the airflow, and the temperature of a plurality of subracks in the cabinet never exceeds the upper limit of temperature, thus ensuring that the cabinet-class communication equipment works normally and prolonging the service life of the cabinet-class communication equipment.

### BRIEF DESCRIPTION OF THE DRAWINGS

Figure 1 shows subracks and circuit boards in cabinet-class communication equipment in the prior art;

Figure 2 shows a structure of the first type of cabinet-class communication apparatus in the prior art;

Figure 3 shows a structure of the second type of cabinet-class communication apparatus in the prior art;

Figure 4 shows a structure of the third type of cabinet-class communication apparatus in the prior art;

Figures 5-8 show structures of the first type of air deflector according to an embodiment of the present invention;

Figure 9 shows a structure of the first type of cabinet-class communication apparatus according to an embodiment of the present invention;

Figure 10 shows a structure of the second type of cabinet-class communication apparatus according to an embodiment of the present invention;

Figure 11 shows a structure of the third type of cabinet-class communication apparatus according to an embodiment of the present invention;

Figure 12 shows a structure of the second type of air deflector according to an embodiment of the present invention;

Figure 13 shows a structure of the fourth type of cabinet-class communication apparatus according to an embodiment of the present invention; and

Figure 14 shows a structure of the third type of air deflector according to an embodiment of the present invention.

### DETAILED DESCRIPTION OF THE EMBODIMENTS

In the case that a plurality of subracks are installed into a cabinet from bottom upward and heat is radiated for the components in the subracks, the heat-radiating airflow according to an embodiment of the present invention is divided into at least two ways, and led into the subracks. Among at least two ways of airflow, one way of airflow which has passed through some subracks is led out of the cabinet from between two adjacent subracks, and at least another way of airflow is led into some other subracks which need to radiate heat, where the way of airflow led out of the cabinet is isolated from the way of airflow led into the cabinet.

In the embodiments of the present invention, an air deflector is set between adjacent subracks in the cabinet so that the air deflector leads one way of airflow that has passed through some subracks out of the cabinet and leads another way of airflow into some other subracks that need to radiate heat. The air deflector is set in many modes. For example, in an instance, the air deflector is independent of the subracks, and is set between two subracks; in an instance, the air deflector acts as part of the subrack, and, when two subracks are overlapped, the air deflector is located between the two subracks.

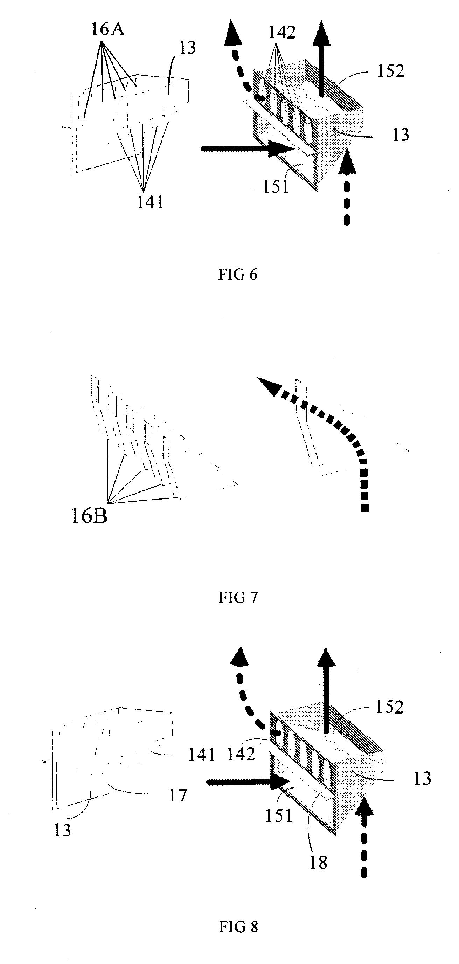

Figure 5 shows a structure of an air deflector according to an embodiment of the present invention. The air deflector includes: a frame 13; a first duct (dotted line in Figure 5) and a second duct (solid line in Figure 5), both set in the frame 13 and isolated from each other. As shown in Figure 6, the air intake vent 141 of the first duct and the air exhaust vent 152 of the second duct are located on two opposite sides of the frame 13; the air intake vent 151 of the second duct and the air exhaust vent 142 of the first duct are located on the same side of the frame 13. As shown in Figure 6, the first duct in the frame 13 is composed of a plurality of cylindrical air channels 16A, between which spacing exists. The spacing constitutes the second duct. As shown in Figure 7, a plurality of air channels 16B in the frame 13 may be set as a tuyere shape to accomplish the same effect of radiating heat.

In this embodiment, as shown in Figure 8, the lateral plane 17 that contains the air intake vent 141 of the first duct on the frame 13 is set as a bevel to reduce air resistance. A baffle 18 is set between the air exhaust vent 142 of the first duct and the air intake vent 151 of the second duct to isolate the first duct and second duct.

Supposing that an air deflector is set between two adjacent subracks in a cabinet-class communication apparatus, the embodiments are detailed below.

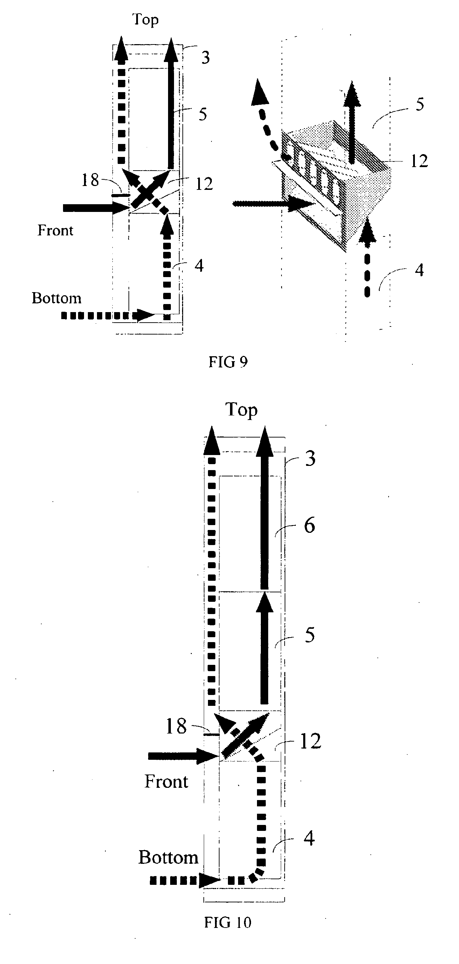

As shown in Figure 9, a first subrack 4 and a second subrack 5 are installed from bottom upward in the cabinet 3; an air deflector 12 is installed between the first subrack 4 and the second subrack 5; the air deflector 12, the first subrack 4, and the second subrack 5 are independent of each other. As shown in Figure 9, when the subracks in the cabinet work, the first way of cooling air is led from the bottom of the cabinet 3 into the first subrack 4. After the circuit board in the first subrack 4 is cooled, the first way of cooling air is led from the first duct in the air deflector 12 to the outside of the first subrack, and expelled from the top of the cabinet 3. Meanwhile, the second way of cooling air is led through the second duct in the air deflector 12 from the front of the cabinet 3 into the second subrack 5, and expelled from the top of the cabinet 3 after cooling the circuit board in the second subrack 5.

A baffle 18 is set on the air deflector 12. Therefore, when the air deflector 12 is installed in the cabinet 3, the baffle 18 fits the inner wall of the cabinet 3 to accomplish the effect of isolating the first duct from the second duct. Therefore, after being led out of the first duct, the first way of cooling airflow is not intermixed with the second way of cooling air led in from the second duct, and the heat of the first subrack 4 is not transmitted to the second subrack 5. In this way, the second subrack 5 accomplishes an ideal effect of radiating heat.

As shown in Figure 10, a first subrack 4, a second subrack 5, and a third subrack 6 are installed from bottom upward in the cabinet 3, and the power consumption of the three subracks is low. An air deflector 12 is installed in the first subrack 4. When the first subrack 4 is installed in the cabinet 3, the air deflector 12 is located between the first subrack 4 and second subrack 5. As shown in Figure 10, when the subracks in the cabinet work, the first way of cooling air is led from the bottom of the cabinet 3 into the first subrack 4. After cooling the circuit board in the first subrack 4, the first way of cooling air is led through the first duct in the air deflector 12 to the outside of the first subrack 4, and expelled from the top of the cabinet 3. Meanwhile, the second way of cooling air is led through the second duct in the air deflector 12 from the front of the cabinet 3 into the second subrack 5 and the third subrack 6 consecutively, and expelled from the top of the cabinet 3 after cooling the circuit boards in the second subrack 5 and the third subrack 6.

In this embodiment, the power consumption of the second subrack 5 and third subrack 6 is low. Therefore, only if the heat of the first subrack 4 is not transmitted into the third subrack 6, the effect of radiating heat of the third subrack 6 is not affected even if the heat of the second subrack 5 is transmitted into the third subrack 6. Nevertheless, the air deflector 12 may also be set between the second subrack 5 and the third subrack 6. In this way, neither the heat of the first subrack 4 nor the heat of the second subrack 5 is transmitted to the third subrack 6, and the third subrack 6 accomplishes more ideal effect of radiating heat.

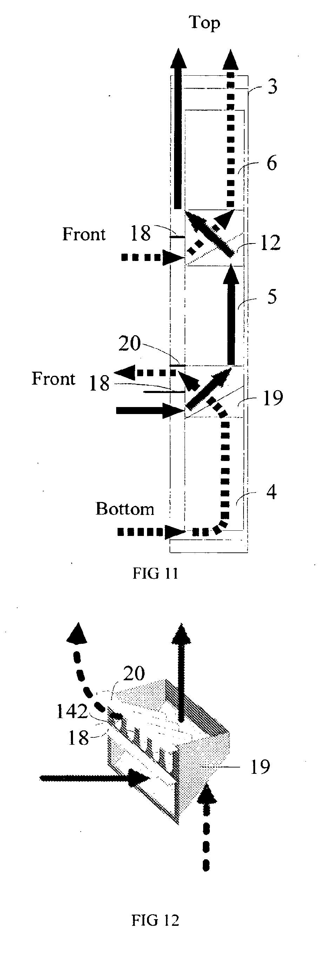

As shown in Figure 11 and Figure 12, a first subrack 4, a second subrack 5, and a third subrack 6 are installed from bottom upward in the cabinet 3, and the power consumption of the three subracks is high, namely, it is not possible to overlay heat of any two subracks. An air deflector 19 is set between the first subrack 4 and the second subrack 5; and an air deflector 12 is set between the second subrack 5 and the third subrack 6. As shown in Figure 12, in contrast with the air deflector 12 in Figure 5, at the side opposite to the baffle 18, a baffle 20 is set at the air exhaust vent 142 of the first duct (dotted line in Figure 12) in the air deflector 19.

As shown in Figure 11, the first way of cooling air, which has passed through the inside of the first subrack 4 and is led out of the first duct (dotted line in the air deflector 19 in Figure 11) in the air deflector 19, is led out of the cabinet 3 by the baffle 20. Meanwhile, the second duct (solid line in the air deflector 19 in Figure 11) in the air deflector 19 carries the second way of cooling air into the second subrack 5. After cooling the electronic components in the second subrack 5, the second way of cooling air is led through the first duct (solid line in the air deflector 12 in Figure 11) in the air deflector 12 to the outside of the second subrack 5, and expelled from the top of the cabinet 3. The air deflector 12 leads the third way of cooling air from the second duct (dotted line in the air deflector 12 in Figure 11) of the air deflector 12 into the third subrack 6. After cooling the electronic components in the third subrack 6, the third way of cooling air is expelled from the top of the cabinet 3. As shown in Figure 11, in order to prevent the second duct in the air deflector 19 from carrying the heat of the first way of cooling air which passes through the inside of the first subrack 4 at the time of leading the second way of cooling air in, the length of the baffle 18 in the air deflector 19 may be prolonged properly to accomplish the effect of isolation. In this way, along the circulation direction of the air, the heat of the first subrack 4, the second subrack 5 and the third subrack 6 is never overlaid, and all the three subracks accomplish the best effect of radiating heat.

In the foregoing embodiment, an air deflector 19 may be set between the second subrack 5 and the third subrack 6 according to actual needs in order to expel the second way of cooling air from the front of the cabinet 3.

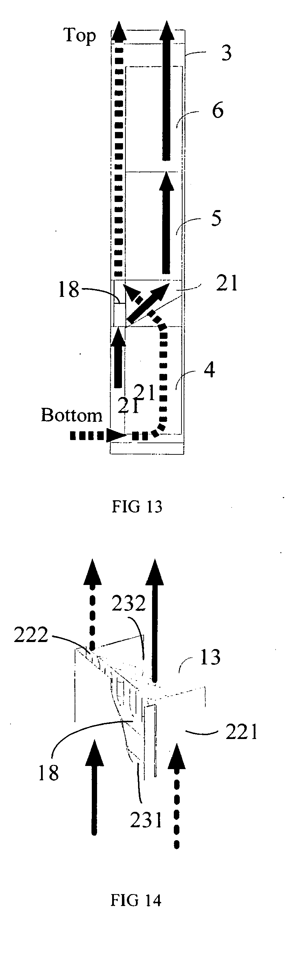

As shown in Figure 13 and Figure 14, a first subrack 4, a second subrack 5, and a third subrack 6 are installed from bottom upward in the cabinet 3, and the spacing from the cabinet 3 to the three subracks is large. An air deflector 21 is set between the first subrack 4 and the second subrack 5. As shown in Figure 12, in contrast with the air deflector 12 in Figure 5, the air intake vent 221 of the first duct in the air deflector 21 and the air exhaust vent 232 of the second duct are located on the two opposite lateral planes of the frame 13 respectively. The air intake vent 231 of the second duct and the air intake vent 221 of the first duct are on the same lateral plane of the frame 13. The air exhaust vent 232 of the second duct and the air exhaust vent 222 of the first duct are on the same lateral plane of the frame 13. A baffle 18 is set between the air exhaust vent 222 of the first duct and the air intake vent 231 of the second duct. This baffle 18 is connected with the frame 13 to accomplish the effect of isolating the first duct from the second duct.

As shown in Figure 13, the cooling air led in from the bottom of the cabinet 3 is divided into two ways. The first way of cooling air is led from the bottom of the cabinet 3 into the first subrack 4. After cooling the circuit board in the first subrack 4, the first way of cooling air is led through the first duct in the air deflector 21 to the outside of the first subrack 4, and expelled from the top of the cabinet 3. Meanwhile, the second way of cooling air led in from the bottom of the cabinet 3 flows through the second duct in the air deflector 21, and then runs into the second subrack 5 and the third subrack 6 consecutively. After cooling the circuit boards in the second subrack 5 and the third subrack 6, the second way of cooling air is also expelled from the top of the cabinet 3.

In the foregoing embodiment, an air deflector 21 may be set between the second subrack 5 and third subrack 6 according to actual needs so that the third subrack 6 accomplishes better effect of radiating heat.

In actual applications, if more than three subracks are installed from top downward in the cabinet, the quantity of air deflectors depends on the actual conditions (such as power consumption of the subracks and the structure of the cabinet). If a plurality of air deflectors are set, one, two or three of air deflector 12, air deflector 19 and air deflector 21 may be selected to improve the heat radiation capability of the subracks in the cabinet.

The embodiments of the present invention lead at least two ways of heat-radiating airflow into the subracks, and lead one way of airflow that has passed through some subracks out of the cabinet from between two adjacent subracks so that this way of airflow does not pass through any other subrack. In this way, the heat accrual of the subracks is controlled in the circulation direction of the airflow, and the temperature of a plurality of subracks in the cabinet never exceeds the upper limit of temperature, thus ensuring that the cabinet-class communication equipment works normally and prolonging the service life of the cabinet-class communication equipment.

It is apparent that those skilled in the art can make various modifications and variations to the present invention without departing from the spirit and scope of the present invention. The present invention is intended to cover such modifications and variations provided that they fall in the scope of protection defined by the following claims or their equivalents.

## Claims

1. A method for radiating heat of subracks in a cabinet, wherein the subracks are installed from bottom upward in the cabinet, and the method comprises:
leading at least two channels of heat-radiating airflow into the subracks;
among at least two channels, leading one channel which has passed through some subracks
out of the cabinet from two adjacent subracks, with this channel passing through no more subracks, and leading another channel into other subracks which need to radiate heat, wherein the channel of airflow led out of the cabinet and the channel of airflow led into the cabinet intersect and are isolated from each other by a first baffle, which is set between an air exhaust vent of the one channel and an air intake vent of the another channel.

2. The method of claim 1, wherein:
the airflow that has passed through some subracks is led from a lateral plane of the cabinet to outside of the cabinet; and/or
the airflow that has passed through some subracks is led from top of the cabinet to the outside of the cabinet.

3. An air deflector (21), comprising:
a frame (13);
a first duct, set inside the frame, wherein an air intake vent and an air exhaust vent of the first duct are located at both sides of the frame; and
a second duct, set inside the frame, wherein an air exhaust vent (232) of the second duct and an air intake vent (221) of the first duct are located at two opposite sides of the frame; and
a first baffle (18), set between the air exhaust vent of the first duct and the air intake vent of the second duct to isolate the second duct and the first duct intersect.

4. The air deflector of claim 3, wherein:
the air intake vent of the second duct and the air exhaust vent of the first duct are located on a same lateral plane of the frame.

5. The air deflector of claim 4, further comprising:a second baffle, set at a side opposite to the first baffle on the air exhaust vent of the first
duct.

6. The air deflector of claim 3, wherein:
the air intake vent and the air exhaust vent of the first duct are located at two opposite sides of the frame respectively, and the air intake vent and the air exhaust vent of the second duct are located at two opposite sides of the frame respectively.

7. The air deflector of claim 3, wherein:
the air intake vent of the first duct is set as a bevel.

8. The air deflector according to any one of claims 3-7, wherein:
the first duct is composed of multiple air channels, spacing exists between the multiple air channels, and the spacing constitutes the second duct.

9. The air deflector of claim 8, wherein the multiple air channels are in a cylinder or tuyere shape.

10. A communication apparatus, comprising a cabinet and at least two subracks, wherein the subracks are installed in the cabinet from bottom upward, and an air deflector is set between at least two adjacent subracks; and wherein
the air deflector (21) comprises:
a frame (13);
a first duct, set inside the frame, wherein an air intake vent and an air exhaust vent of the first duct are located at both sides of the frame; and
a second duct, set inside the frame, wherein an air exhaust vent of the second duct and an air intake vent of
the first duct are located at two opposite sides of the frame; and
a first baffle (18), set between the air exhaust vent of the first duct and the air intake vent of the second duct to isolate the second duct and the first duct intersect; wherein:
among the two ducts, one duct leads airflow that has passed through some subracks out of the cabinet and this airflow does not pass through any other subrack, and the other duct leads airflow that does not pass through any subrack into other subracks that need heat radiation.

11. The communication apparatus of claim 10, wherein the air intake vent of the second duct and the air exhaust vent of the first duct in the air deflector are located on a same lateral plane of the frame.

12. The communication apparatus of claim 11, wherein the air deflector further comprises:
a second baffle, set at a side opposite to the first baffle on the air exhaust vent of the first duct.

13. The communication apparatus of claim 10, wherein:
the air intake vent and the air exhaust vent of the first duct in the air deflector are located at two opposite sides of the frame respectively, and the air intake vent and the air exhaust vent of the second duct are located at two opposite sides of the frame respectively.

14. The communication apparatus of claim 13, wherein:
a lateral plane of the air intake vent of the first duct set in the air deflector is a bevel.

15. The communication apparatus according to any one of claims 10-14, wherein:
the first duct in the air deflector is composed of multiple air channels, spacing exists between the multiple air channels, and the spacing constitutes the second duct.

16. The communication apparatus of claim 15, wherein the multiple air channels are in a cylinder or tuyere shape.

17. The communication apparatus of claim 10, wherein:
spacing exists between the lateral plane which has an air intake vent on the cabinet and the subracks, and a channel of airflow which has passed through some subracks is led out of the cabinet through the spacing.

18. The communication apparatus of claim 17, wherein:
the air exhaust vent for exhaling the airflow on the cabinet and the air intake vent are set on a same lateral plane of the cabinet, and the air exhaust vent is located above the air intake vent.

19. The communication apparatus of claim 17, wherein:
the air exhaust vent for exhaling the airflow on the cabinet is located on top of the cabinet, and the airflow which has passed through some subracks in the cabinet is led out of the cabinet through the air exhaust vent.

20. The communication apparatus of claim 17, wherein:
the air exhaust vent is set at the lateral plane and the top of the cabinet, the airflow which has passed through some subracks nearby bottom of the cabinet is led out of the cabinet through the air exhaust vent set on the lateral plane of the cabinet; the airflow which has passed through some subracks nearby the top of the cabinet is led out of the cabinet through the air exhaust vent set at the top of the cabinet.

## Patentansprüche

1. Verfahren zum Abstrahlen von Wärme von Untergestellen in einem Schrank, wobei die Untergestelle von einem Boden aufwärts in dem Schrank installiert sind, wobei das Verfahren enthält:
Führen von wenigstens zwei Kanälen einer Wärme abstrahlenden Luftströmung in die Untergestelle;
von wenigstens zwei Kanälen Führen eines Kanals, der sich durch einige Untergestelle bewegt hat, aus dem Schrank von zwei benachbarten Untergestellen, wobei sich dieser Kanal durch keine weiteren Untergestelle bewegt, und Führen eines weiteren Kanals in andere Untergestelle, die Wärme abstrahlen müssen, wobei sich der Kanal der aus dem Schrank herausgeführten Luftströmung und der Kanal der in den Schrank geführten Luftströmung schneiden und voneinander durch einen ersten Schirm isoliert sind, der zwischen einer Luftauslassöffnung des einen Kanals und einer Lufteinlassöffnung des anderen Kanals angeordnet ist.

2. Verfahren nach Anspruch 1, wobei:
die Luftströmung, die sich durch einige Untergestelle bewegt hat, aus einer seitlichen Ebene des Schranks in die äußere Umgebung des Schranks geführt wird; und/oder die Luftströmung, die sich durch einige Untergestelle bewegt hat, von der Oberseite des Schranks zur äußeren Umgebung des Schranks geführt wird.

3. Luftablenkeinrichtung (21), mit:
einem Rahmen (13);
einer ersten Rohrleitung, die in dem Rahmen angeordnet ist, wobei sich eine Lufteinlassöffnung und eine Luftauslassöffnung der ersten Rohrleitung auf beiden Seiten des Rahmens befinden; und
einer zweiten Rohrleitung, die in dem Rahmen angeordnet ist, wobei sich eine Luftauslassöffnung (232) der zweiten Rohrleitung und eine Lufteinlassöffnung (221) der ersten Rohrleitung auf zwei gegenüberliegenden Seiten des Rahmens befinden; und
einem ersten Schirm (18), der zwischen der Luftauslassöffnung der ersten Rohrleitung und der Lufteinlassöffnung der zweiten Rohrleitung angeordnet ist, um die zweite Rohrleitung und die erste Rohrleitung, die sich schneiden, zu isolieren.

4. Luftablenkeinrichtung nach Anspruch 3, wobei:
die Lufteinlassöffnung der zweiten Rohrleitung und die Luftauslassöffnung der ersten Rohrleitung sich in derselben seitlichen Ebene des Rahmens befinden.

5. Luftablenkeinrichtung nach Anspruch 4, die ferner einen zweiten Schirm enthält, der auf einer Seite gegenüber dem ersten Schirm an der Luftauslassöffnung der ersten Rohrleitung angeordnet ist.

6. Luftablenkeinrichtung nach Anspruch 3, wobei:
die Lufteinlassöffnung und die Luftauslassöffnung der ersten Rohrleitung sich auf zwei jeweils gegenüberliegenden Seiten des Rahmens befinden und die Lufteinlassöffnung und die Luftauslassöffnung der zweiten Rohrleitung sich auf zwei jeweils gegenüberliegenden Seiten des Rahmens befinden.

7. Luftablenkeinrichtung nach Anspruch 3, wobei:
die Lufteinlassöffnung der ersten Rohrleitung schräg angeordnet ist.

8. Luftablenkeinrichtung nach einem der Ansprüche 3-7, wobei:
die erste Rohrleitung aus mehreren Luftkanälen gebildet ist, wobei zwischen den mehreren Luftkanälen ein Zwischenraum vorhanden ist und wobei der Zwischenraum die zweite Rohrleitung bildet.

9. Luftablenkeinrichtung nach Anspruch 8, wobei die mehreren Luftkanäle zylinderförmig oder düsenförmig sind.

10. Kommunikationsvorrichtung, die einen Schrank und wenigstens zwei Untergestelle enthält, wobei die Untergestelle in dem Schrank vom Boden aufwärts installiert sind, und eine Luftablenkeinrichtung zwischen wenigstens zwei benachbarten Untergestellen angeordnet ist; und wobei
die Luftablenkeinrichtung (21) enthält:
einen Rahmen (13);
eine erste Rohrleitung, die in dem Rahmen angeordnet ist, wobei sich eine Lufteinlassöffnung und eine Luftauslassöffnung der ersten Rohrleitung auf beiden Seiten des Rahmens befinden; und
eine zweite Rohrleitung, die in dem Rahmen angeordnet ist, wobei sich eine Luftauslassöffnung der zweiten Rohrleitung und eine Lufteinlassöffnung der ersten Rohrleitung auf zwei gegenüberliegenden Seiten des Rahmens befinden; und
einen ersten Schirm (18), der zwischen der Luftauslassöffnung der ersten Rohrleitung und der Lufteinlassöffnung der zweiten Rohrleitung angeordnet ist, um die zweite Rohrleitung und die erste Rohrleitung, die sich schneiden, zu isolieren; wobei:
von den zwei Rohrleitungen eine Rohrleitung eine Luftströmung, die sich durch einige Untergestelle bewegt hat, aus dem Schrank leitet, wobei sich diese Luftströmung nicht durch irgendein anderes Untergestell bewegt, und die andere Rohrleitung eine Luftströmung, die sich nicht durch irgendein Untergestell bewegt, in andere Untergestelle, die eine Wärmeabstrahlung erfordern, leitet.

11. Kommunikationsvorrichtung nach Anspruch 10, wobei sich die Lufteinlassöffnung der zweiten Rohrleitung und die Luftauslassöffnung der ersten Rohrleitung in der Luftablenkeinrichtung in derselben seitlichen Ebene des Rahmens befinden.

12. Kommunikationsvorrichtung nach Anspruch 11, wobei die Luftablenkeinrichtung ferner enthält:
einen zweiten Schirm, der auf einer Seite gegenüber dem ersten Schirm bei der Luftauslassöffnung der ersten Rohrleitung angeordnet ist.

13. Kommunikationsvorrichtung nach Anspruch 10, wobei:
die Lufteinlassöffnung und die Luftauslassöffnung der ersten Rohrleitung in der Luftablenkeinrichtung sich auf zwei jeweils gegenüberliegenden Seiten des Rahmens befinden und die Lufteinlassöffnung und die Luftauslassöffnung der zweiten Rohrleitung sich auf zwei jeweils gegenüberliegenden Seiten des Rahmens befinden.

14. Kommunikationsvorrichtung nach Anspruch 13, wobei:
eine seitliche Ebene der Lufteinlassöffnung der ersten Rohrleitung, die in der Luftablenkeinrichtung angeordnet ist, schräg orientiert ist.

15. Kommunikationsvorrichtung nach einem der Ansprüche 10-14, wobei:
die erste Rohrleitung in der Luftablenkeinrichtung aus mehreren Luftkanälen gebildet ist, wobei zwischen den mehreren Luftkanälen ein Zwischenraum vorhanden ist und der Zwischenraum die zweite Rohrleitung bildet.

16. Kommunikationsvorrichtung nach Anspruch 15, wobei die mehreren Luftkanäle zylinderförmig oder düsenförmig sind.

17. Kommunikationsvorrichtung nach Anspruch 10, wobei:
zwischen der seitlichen Ebene, die eine Lufteinlassöffnung am Schrank besitzt, und den Untergestellen ein Zwischenraum vorhanden ist und ein Kanal einer Luftströmung, die sich durch einige Untergestelle bewegt hat, aus dem Schrank durch den Zwischenraum geführt wird.

18. Kommunikationsvorrichtung nach Anspruch 17, wobei:
die Luftauslassöffnung zum Auslassen der Luftströmung aus dem Schrank und die Lufteinlassöffnung in derselben seitlichen Ebene des Schranks angeordnet sind und die Luftauslassöffnung sich über der Lufteinlassöffnung befindet.

19. Kommunikationsvorrichtung nach Anspruch 17, wobei:
die Luftauslassöffnung zum Auslassen der Luftströmung aus dem Schrank sich an der Oberseite des Schranks befindet und die Luftströmung, die sich durch einige Untergestelle in dem Schrank bewegt hat, aus dem Schrank durch die Luftauslassöffnung geführt wird.

20. Kommunikationsvorrichtung nach Anspruch 17, wobei:
die Luftauslassöffnung in der seitlichen Ebene und in der Oberseite des Schranks angeordnet ist, wobei die Luftströmung, die sich durch einige Untergestelle in der Nähe des Bodens des Schranks bewegt hat, aus dem Schrank durch die Luftauslassöffnung geführt wird, die in der seitlichen Ebene des Schranks angeordnet ist; wobei die Luftströmung, die sich durch einige Untergestelle in der Nähe der Oberseite des Schranks bewegt hat, aus dem Schrank durch die Luftauslassöffnung geführt wird, die an der Oberseite des Schranks angeordnet ist.

## Revendications

1. Procédé d'irradiation de chaleur de casiers dans une armoire, dans lequel les casiers sont installés de bas en haut dans l'armoire, et le procédé comprenant les étapes consistant à :
guider au moins deux canaux de flux d'air irradiant de la chaleur dans les casiers ;
parmi au moins deux canaux, conduire un canal qui est passé à travers certains casiers hors de l'armoire depuis deux casiers adjacents, ce canal ne passant plus à travers aucun casier supplémentaire, et guider un autre canal dans d'autres casiers qui doivent irradier de la chaleur, le canal de flux d'air guidé hors de l'armoire et le canal de flux d'air guidé dans l'armoire se croisant et étant isolés l'un de l'autre par une première chicane, qui est placée entre un évent d'échappement d'air d'un canal et un évent d'admission d'air de l'autre canal.

2. Procédé selon la revendication 1, dans lequel :
le flux d'air qui est passé à travers certains casiers est guidé depuis un plan latéral de l'armoire jusqu'à l'extérieur de l'armoire ; et/ou
le flux d'air qui est passé à travers certains casiers est guidé depuis le haut de l'armoire jusqu'à l'extérieur de l'armoire.

3. Déflecteur d'air (21), comprenant :
un cadre (13) ;
un premier conduit, placé à l'intérieur du cadre, dans lequel un évent d'admission d'air et un évent d'échappement d'air du premier conduit sont situés sur les deux côtés du cadre ; et
un deuxième conduit, placé à l'intérieur du cadre, un évent d'échappement d'air (232) du deuxième conduit et un évent d'admission d'air (221) du premier conduit étant situés sur deux côtés opposés du cadre ; et
une première chicane (18), placée entre l'évent d'échappement d'air du premier conduit et l'évent d'admission d'air du deuxième conduit, pour isoler l'intersection du deuxième conduit et du premier conduit.

4. Déflecteur d'air selon la revendication 3, dans lequel :
l'évent d'admission d'air du deuxième conduit et l'évent d'échappement d'air du premier conduit sont situés sur un même plan latéral du cadre.

5. Déflecteur d'air selon la revendication 4, comprenant en outre : une deuxième chicane, placée sur un côté opposé à la première chicane sur l'évent d'échappement d'air du premier conduit.

6. Déflecteur d'air selon la revendication 3, dans lequel :
l'évent d'admission d'air et l'évent d'échappement d'air du premier conduit sont situés sur deux côtés opposés du cadre, respectivement, et l'évent d'admission d'air et
l'évent d'échappement d'air du deuxième conduit sont situés sur deux côtés opposés du cadre, respectivement.

7. Déflecteur d'air selon la revendication 3, dans lequel :
l'évent d'admission d'air du premier conduit est placé sous forme biseautée.

8. Déflecteur d'air selon l'une quelconque des revendications 3 à 7, dans lequel :
le premier conduit est constitué de plusieurs canaux d'air, un espacement existant entre les plusieurs canaux d'air, et l'espacement constituant le deuxième conduit.

9. Déflecteur d'air selon la revendication 8, dans lequel les plusieurs canaux d'air sont en forme de cylindre ou de tuyère.

10. Appareil de communication, comprenant une armoire et au moins deux casiers, les casiers étant installés dans l'armoire de bas en haut, et un déflecteur d'air étant placé entre au moins deux casiers adjacents ; et dans lequel
le déflecteur d'air (21) comprend :
un cadre (13) ;
un premier conduit, placé à l'intérieur du cadre, un évent d'admission d'air et un évent d'échappement d'air du premier conduit étant situés sur les deux côtés du cadre ; et
un deuxième conduit, placé à l'intérieur du cadre, un évent d'échappement d'air du deuxième conduit et un évent d'admission d'air du premier conduit étant situés sur deux côtés opposés du cadre ; et
une première chicane (18), placée entre l'évent d'échappement d'air du premier conduit et l'évent d'admission d'air du deuxième conduit pour isoler l'intersection du deuxième conduit et du premier conduit ;
parmi les deux conduits, un conduit guidant le flux d'air qui est passé à travers certains casiers hors de l'armoire et ce flux d'air ne passant à travers aucun autre casier, et l'autre conduit guidant le flux d'air qui ne passe à travers aucun casier dans d'autres casiers qui ont besoin d'une irradiation de chaleur.

11. Appareil de communication selon la revendication 10, dans lequel l'évent d'admission d'air du deuxième conduit et l'évent d'échappement d'air du premier conduit dans le déflecteur d'air sont situés sur un même plan latéral du cadre.

12. Appareil de communication selon la revendication 11, dans lequel le déflecteur d'air comprend en outre :
une deuxième chicane, placée sur un côté opposé à la première chicane sur l'évent d'échappement d'air du premier conduit.

13. Appareil de communication selon la revendication 10, dans lequel :
l'évent d'admission d'air et l'évent d'échappement d'air du premier conduit dans le déflecteur d'air sont situés sur deux côtés opposés du cadre respectivement, et l'évent d'admission d'air et l'évent d'échappement d'air du deuxième conduit sont situés sur deux côtés opposés du cadre, respectivement.

14. Appareil de communication selon la revendication 13, dans lequel :
un plan latéral de l'évent d'admission d'air du premier conduit placé dans le déflecteur d'air est formé en tant que biseau.

15. Appareil de communication selon l'une quelconque des revendications 10 à 14, dans lequel :
le premier conduit dans le déflecteur d'air est composé de plusieurs canaux d'air, un espacement existe entre les plusieurs canaux d'air, et l'espacement constitue le deuxième conduit.

16. Appareil de communication selon la revendication 15, dans lequel les plusieurs canaux d'air sont en forme de cylindre ou de tuyère.

17. Appareil de communication selon la revendication 10, dans lequel :
un espacement existe entre le plan latéral qui présente un évent d'admission d'air sur l'armoire et les casiers, et un canal de flux d'air qui est passé à travers certains casiers est guidé hors de l'armoire à travers l'espacement.

18. Appareil de communication selon la revendication 17, dans lequel :
l'évent d'échappement d'air pour laisser s'échapper le flux d'air sur l'armoire et l'évent d'admission d'air sont placés sur un même plan latéral de l'armoire, et l'évent d'échappement d'air est situé au-dessus de l'évent d'admission d'air.

19. Appareil de communication selon la revendication 17, dans lequel :
l'évent d'échappement d'air pour laisser s'échapper le flux d'air sur l'armoire est situé sur le haut de l'armoire et le flux d'air qui est passé à travers certains casiers dans l'armoire est guidé hors de l'armoire à travers l'évent d'échappement d'air.

20. Appareil de communication selon la revendication 17, dans lequel :
l'évent d'échappement d'air est placé au niveau du plan latéral et en haut de l'armoire, le flux d'air qui est passé à travers certains casiers à proximité de la base de l'armoire est guidé hors de l'armoire à travers l'évent d'échappement d'air placé sur le plan latéral de l'armoire ; le flux d'air qui est passé à travers certains casiers à proximité du haut de l'armoire est guidé hors de l'armoire à travers l'évent d'échappement d'air placé en haut de l'armoire.
